# EUROPEAN PATENT APPLICATION

(11) **EP 1 638 142 A2**
(43) Date of publication of application: **22.03.2006**
(21) Application number: 05019824.1
(22) Date of filing: 13.09.2005
(51) Int. Cl.: H01L 21/8244, H01L 27/11

(54) **SRAM cell with stacked thin-film transistors**

(30) Priority: 20.09.2004 KR 2004075252; 24.01.2005 US 41675
(71) Applicant: Samsung Electronics Co., Ltd., Yeongtong-gu Suwon-si, Gyeonggi-do (KR)
(72) Inventor: Suh, Young-Ho, Suwon-si Gyeonggi-do (KR); Byun, Hyun-Geun, Yongin-si Gyeonggi-do (KR)
(74) Representative: Patentanwälte Ruff, Wilhelm, Beier, Dauster & Partner

(57) **Abstract**

An integrated circuit memory device according to the invention includes a first column (412) of memory cells (4121) electrically coupled to a first pair of bit lines and a bit line precharge and selection circuit (414,416) which includes a stacked arrangement of a PMIS and a NMOS transistor (N41). These transistors may be thin-film transistors and may include a first PMOS thin-film pull-up transistor and a first NMOS thin-film pass transistor. These transistors are electrically coupled to one of the first pair of bit lines (PBL). The first column of memory cells may include a column of TFT SRAM cells.

## Description

The invention relates to an integrated circuit memory device according to the preamble of claim 1. This application claims priority to Korean Application Serial No. 2004-75252, filed September 20, 2004, the disclosure of which is hereby fully incorporated herein by reference.

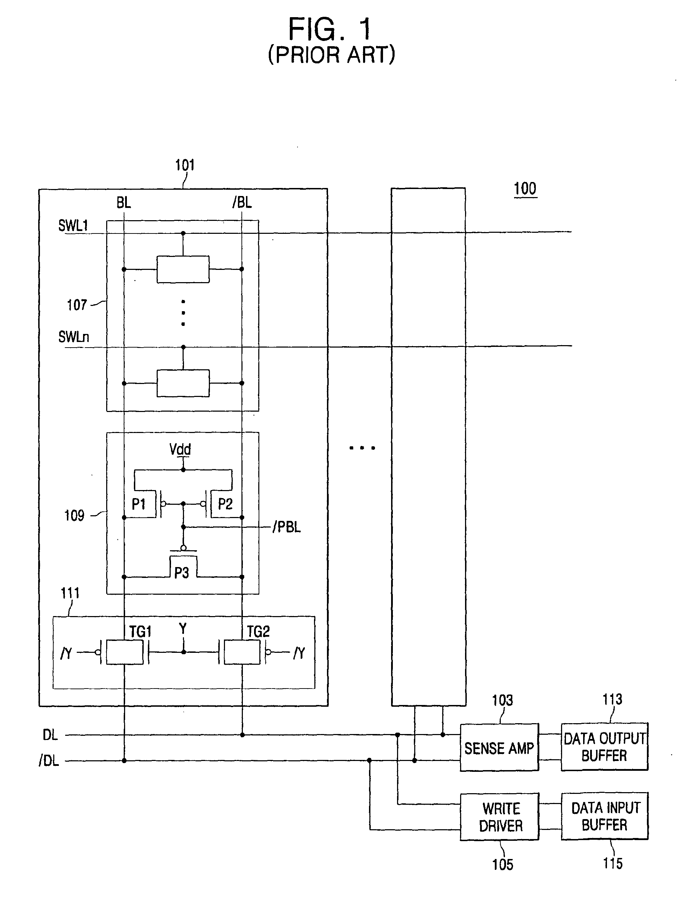

Conventional memory devices include a class of memory devices referred to as static random access memory (SRAM) devices. As illustrated by FIG. 1, a conventional SRAM device **100** includes a plurality of column units **101** arranged side-by-side in a semiconductor substrate. Each of the column units **101** is illustrated as including a column of SRAM cells **107,** a bit line precharging and equalization circuit 109, which is responsive to an active low bit line precharge signal /PBL, and a bit line selection circuit **111,** which is responsive to a pair of column selection signals Y and /Y. The column of SRAM cells **1**07 is electrically coupled to a corresponding pair of bit lines (BL and /BL) and each SRAM cell within the column **107** is responsive to a corresponding word line signal (SWL1 - SWLn). The bit line precharging and equalization circuit **109** includes PMOS transistors P1-P3 and the bit line selection circuit **111** includes transmission gates TG1 and TG2. As will be understood by those skilled in the art, setting the bit line precharge signal /PBL low during a precharge time interval causes both bit lines BL and /BL to be equalized at a logic 1 voltage level (e.g., Vdd). In addition, setting the bit line precharge signal /PBL high and the true column selection signal Y high (and /Y low) will cause the pair of bit lines BL and /BL to be connected to a pair of data lines DL and /DL. During a read operation, these data lines DL and /DL provide read data to a sense amplifier 103 and a data output buffer **113** within a read path of the memory device. During a write operation, the data lines DL and /DL receive write data from a write driver 105, which is electrically coupled to a data input buffer **115.**

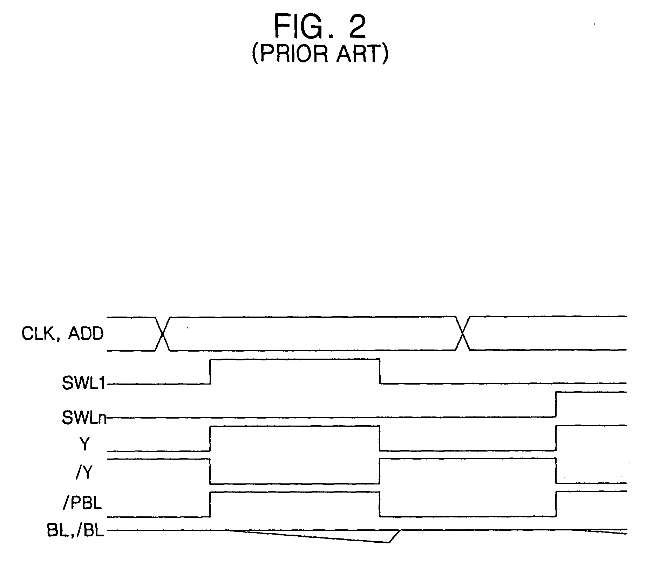

As illustrated by the timing diagram of FIG. 2, a leading edge of a clock signal CLK (for a synchronous SRAM device) or an address ADD (for an asynchronous SRAM device) may result in the switching of the word line, column selection and bit line precharge signals illustrated by FIG. 1. In particular, prior to receipt of a leading edge of the clock signal CLK (or address ADD), the bit line precharge signal /PBL is held low and the pair of bit lines BL and /BL are held high at logic 1 voltage levels. Then, upon receipt of the leading edge, the bit line precharge signal /PBL is switched high to an inactive level, a selected word line SWL1 is switched high to activate a row of SRAM cells and the column selection signals Y and /Y are set high and low, respectively, to thereby electrically couple the pair of bit lines BL and /BL to the corresponding pair of data lines DL and /DL. These switching operations result in a transfer of differential read data from a selected memory cell to the corresponding bit lines BL and /BL and then to the corresponding data lines DL and /DL. This differential read data is then detected and amplified by the sense amplifier 103 and output to the data output buffer **113.**

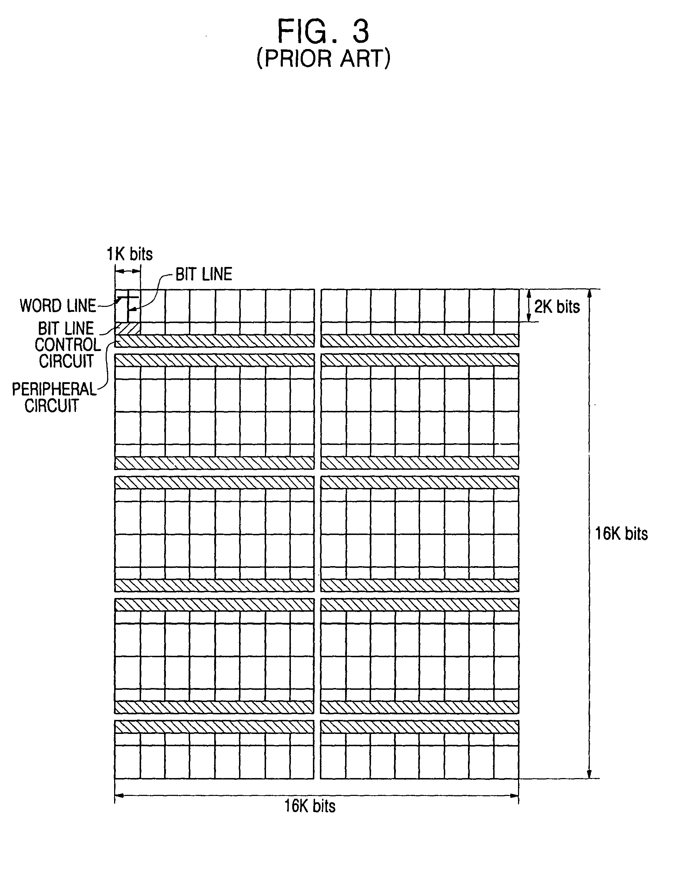

A possible layout of the SRAM device **100** of FIG. 1 is illustrated by FIG. 3. In particular, FIG. 3 illustrates an SRAM device having a capacity of 16K bits by 16K bits, with each sub-block of 1 K bits by 2K bits worth of memory being arranged as 2048 rows of SRAM cells extending in a horizontal word line direction by 1024 columns of SRAM cells extending in a vertical bit line direction. Each sub-block is associated with a corresponding bit line control circuit and peripheral circuit. Unfortunately, the bit line capacitance associated with each pair of bit lines (BL and /BL), which span 2048 rows of SRAM cells, may be excessive and thereby increase active power (i.e., switching power) and access time during reading and writing operations.

To address these problems of excessive active power and access time, integrated circuit memory devices may utilize hierarchical bit line selection circuits that reduce bit line capacitance. In some of these memory devices, two or more SRAM cells may be used in combination to divide a bit line into two or more sub bit-lines, which are combined to form two or more levels of hierarchy. One such memory device is disclosed in an article by A. Karandikar et al., entitled "Low Power SRAM Design Using Hierarchical Divided Bit-Line Approach," ICCD Proceedings, pp. 82-88, Oct. 1998. In particular, the Karandikar et al. article illustrates how the drain capacitance loading on a bit line can be reduced by reducing the number of access transistors connected to the bit line by a factor of four or more. However, this advantageous reduction in bit line capacitance typically incurs a layout area penalty because additional column decoding and related circuits are required to control the additional access transistors at the multiple levels of hierarchy. Patent publication US 5,715,189 also discloses a memory device having a hierarchical bit line arrangement.

Conventional techniques to achieve reductions in layout area of SRAM memory devices are disclosed in an article by S.M. Jung et al., entitled "The Revolutionary and Truly 3-Dimensional 25F² SRAM Technology with the Smallest S³ (Stacked Single-Crystal Si) Cell, 0.16 um², and SSTFT (Stacked Single-crystal Thin Film Transistor) for Ultra High Density SRAM," Symposium on VLSI Technology Digest, pp. 228-229, June 2004, the disclosure of which is hereby incorporated herein by reference. In this article, an SRAM cell having a reduced cell size is described as having two thin-film PMOS load transistors and two thin-film NMOS pass transistors stacked over two planar NMOS pull-down transistors. In particular, FIG. 3 of this article shows a 6T SRAM cell having a pair of NMOS bulk transistors, a pair of PMOS load transistors on an interlayer dielectric layer (ILD1) and a pair of NMOS access transistors on another interlayer dielectric layer (ILD2).

It is the technical problem underlying the invention to provide an integrated circuit memory device of the kind mentioned at the outset which allows to further minimize the layout area.

The invention solves this problem by providing an integrated circuit memory device having the features of claim 1. Advantageous embodiments of the invention are given in the subclaims, the wording of which is herewith incorporated into the description to avoid unnecessary text repetition.

Integrated circuit memory devices according to embodiments of the invention utilize hierarchical bit line selection circuits to reduce active power requirements by lowering bit line capacitance. These memory devices also include arrangements of stacked thin-film transistors (TFTs), which reduce the layout area requirements of bit line precharge and selection circuits. According to some of these embodiments of the invention, a memory device includes at least a first column of memory cells electrically coupled to a first pair of bit lines. A bit line precharge and selection circuit is also provided. This bit line precharge and selection circuit includes a stacked arrangement of a first PMOS pull-up transistor and a first NMOS pass transistor electrically coupled to one of the first pair of bit lines. This stacked arrangement of transistors may be disposed above a memory core portion of a semiconductor substrate and thereby reduce the presence of alternating P-type and N-type conductivity regions within the memory core portion. This reduction in alternating P-type and N-type conductivity regions operates to inhibit an occurrence of parasitic latch-up, which may result in potentially destructive regenerative current conduction within the substrate.

According to preferred aspects of these embodiments, the first PMOS pull-up transistor is a PMOS TFT and the first NMOS pass transistor is an NMOS TFT. The first current carrying terminal of the PMOS TFT is electrically connected to a first current carrying terminal of the NMOS TFT and a true one of the first pair of bit lines. A gate terminal of the PMOS TFT is electrically connected to a gate terminal of the NMOS TFT. A second current carrying terminal of the PMOS TFT is electrically connected to a power supply line (Vdd) and a second current carrying terminal of the NMOS TFT is electrically connected to a global bit line.

Other embodiments of the invention include an integrated circuit memory device having at least first and second columns of memory cells therein, which are electrically coupled to first and second pairs of bit lines, respectively, and a first bit line precharge and selection circuit. This first bit line precharge and selection circuit includes a stacked arrangement of a first PMOS TFT and a first NMOS TFT electrically coupled to a true one of the first pair of bit lines and a stacked arrangement of a second PMOS TFT and a second NMOS TFT electrically coupled to a complementary one of the first pair of bit lines. A pair of global bit lines is electrically coupled to the first and second NMOS TFTs. The memory device also includes a pair of data lines and a precharge and equalization circuit electrically coupled to the pair of global bit lines. In addition, a global bit line selection circuit is provided, which is electrically coupled to the precharge and equalization circuit and the pair of data lines.

Still further embodiments of the invention include a first column of TFT SRAM cells electrically coupled to a first pair of bit lines. These TFT SRAM cells may include two thin-film PMOS load transistors and two thin-film NMOS pass/access transistors stacked over two planar NMOS pull-down transistors, which are disposed within a semiconductor substrate. A bit line precharge and selection circuit is provided. This circuit includes a stacked arrangement of a first PMOS TFT and a first NMOS TFT electrically coupled to one of the first pair of bit lines. A first current carrying terminal (e.g., drain) of the PMOS TFT is electrically connected to a first current carrying terminal of the NMOS TFT and a true one of the first pair of bit lines. A gate terminal of the PMOS TFT is electrically connected to a gate terminal of the NMOS TFT. A second current carrying terminal (e.g., source) of the PMOS TFT is electrically connected to a power supply line and a second current carrying terminal of the NMOS TFT is electrically connected to a global bit line.

Advantageous embodiments of the invention are described below and shown in the drawings in which also the conventional embodiments are shown as explained above to facilitate the understanding of the invention. In the drawings:
- Fig. 1: is an electrical schematic of a conventional SRAM device,
- Fig. 2: is a timing diagram that illustrates operation of the SRAM device of Fig. 1,
- Fig. 3: is a block diagram of a 16K by 16K conventional SRAM device,
- Fig. 4: is an electrical schematic of an integrated circuit memory device according to the invention,
- Fig. 5: is a timing diagram that illustrates operation of the memory device of Fig. 4,
- Fig. 6: is a cross-sectional view of a stacked thin-film transistor structure according to the invention,
- Fig. 7A: is a block diagram of a 16K by 16K memory device according to of the invention, and
- Fig. 7B: is a block diagram of another 16K by 16K memory device according to of the invention.

The invention now will be described more fully herein with reference to the accompanying drawings, in which advantageous embodiments of the invention are shown. In the drawings, the thickness of layers and regions may be exaggerated for clarity of description. It will also be understood that when a layer is referred to as being "on" another layer or substrate, it can be directly on the other layer or substrate, or intervening layers may also be present. Like reference numerals refer to like elements throughout. Signals may also be synchronized and/or undergo minor boolean operations (e.g., inversion) without being considered different signals. The suffix B (or prefix symbol "/") to a signal name may also denote a complementary data or information signal or an active low control signal, for example.

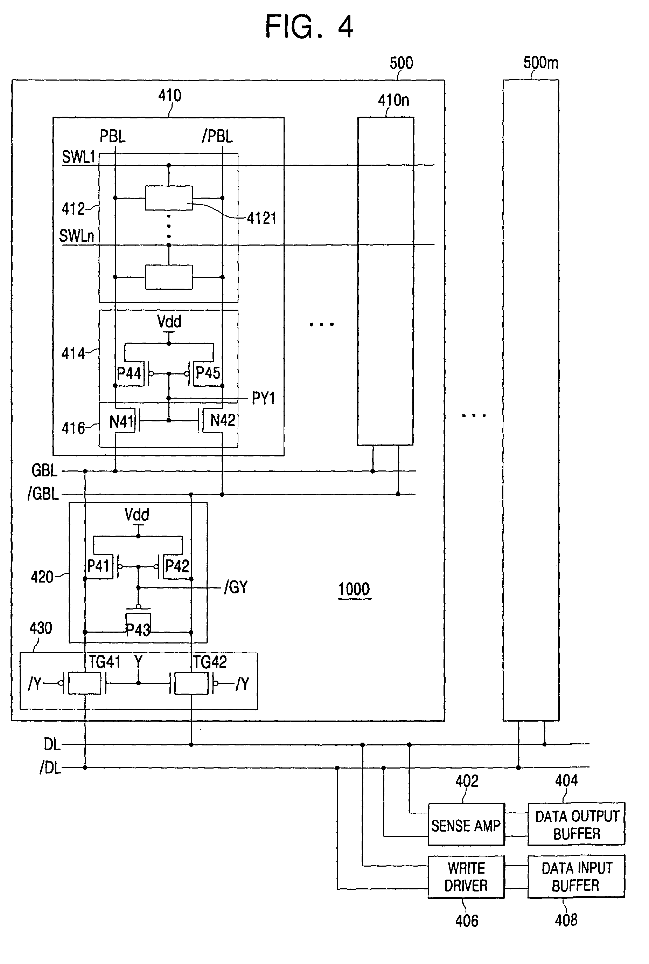

Referring now to FIG. 4, an integrated circuit memory device **1000** according to an embodiment of the invention includes a plurality of equivalent global column units **500-500m** connected to a pair of differential data lines DL and /DL. Data provided to the data lines DL and /DL during read operations is sensed and amplified by a sense amplifier **402** and passed to a data output buffer **404.** During write operations, write data is received by a data input buffer **408** and then passed to a write driver **406,** which drives the data lines DL and /DL. Each of the global column units includes a plurality of partial column units **410-410n** connected to a pair of global bit lines GBL and /GBL. The first partial column unit **410** includes a column **412** of SRAM memory cells **4121** coupled to a pair of partial bit lines PBL and /PBL. This column **412** of SRAM memory cells **4121** is illustrated as including 1 to n rows of SRAM memory cells **4121,** which are electrically coupled to respective ones of the word lines SWL1-SWLn. These SRAM memory cells **4121** may be thin-film transistor (TFT) SRAM cells, which utilize an arrangement of thin-film transistors stacked on top of planar transistors. In particular, each of these TFT SRAM cells may be a 6T cell including two TFT P-type pull-up transistors and two TFT N-type access transistors stacked over two planar field effect transistors, which are disposed within a semiconductor substrate. An exemplary embodiment of a six transistor (6T) TFT SRAM cell is disclosed in the aforementioned S.M. Jung article, which is hereby incorporated herein by reference. The pair of partial bit lines PBL and /PBL electrically couples the column **412** of SRAM memory cells **4121** to a partial bit line precharging circuit **414** and a partial bit line selection circuit **416.** The partial bit line precharging circuit **414** is illustrated as including a pair of PMOS pull-up transistors P44 and P45 and the partial bit line selection circuit **416** is illustrated as including a pair of NMOS pass transistors N41 and N42. The gate terminals of these transistors N41, N42, P44 and P45 are connected to a partial column selection line PY1. When the partial column selection line PY1 is switched high-to-low during a precharge time interval, the pair of partial bit lines PBL and /PBL are precharged to a logic 1 voltage level (e.g., Vdd). However, when the partial column selection line PY1 is switched low-to-high, the NMOS pass transistors N41 and N42 are turned on to thereby electrically connect the partial bit lines PBL and /PBL to the global bit lines GBL and /GBL. The low-to-high switching of the partial column selection line PY1 preferably includes driving the partial column selection line PY1 to a boosted voltage level Vpp. The value of this boosted voltage level Vpp may equal a sum of the power supply voltage Vdd (e.g., 1.2 Volts) and Vth (e.g., 0.6 Volts), where Vth equals a threshold voltage of the NMOS pass transistors N41 and N42. Driving the partial column selection line PY1 to a boosted voltage level Vpp enables each of the global bit lines GBL and /GBL to support a full rail logic 1 voltage during read operations and enables each of the partial bit lines PBL and /PBL to support a full rail logic 1 voltage during write operations.

The data path associated with the global column unit **500** also includes a global bit line precharging and equalizing circuit **420** and a global bit line selection circuit **430.** The global bit line precharging and equalizing circuit **420** includes PMOS pull-up transistors P41 and P42 and a PMOS equalizing transistor P43. The source terminals of the PMOS pull-up transistors P41 and P42 are electrically connected to a power supply line Vdd and the drain terminals of the PMOS pull-up transistors P41 and P42 are electrically connected to the global bit lines GBL and /GBL. The source and drain terminals of the PMOS equalizing transistor P43 are also electrically connected to the drain terminals of the PMOS pull-up transistors P41 and P42. The gate terminals of the PMOS transistors P41-P43 are responsive to an active low global column selection signal /GY. The global bit line selection circuit **430** includes a pair of transmission gates TG41 and TG42, which are electrically coupled to the pair of data lines DL and /DL. These transmission gates are responsive to the column selection signals Y and /Y.

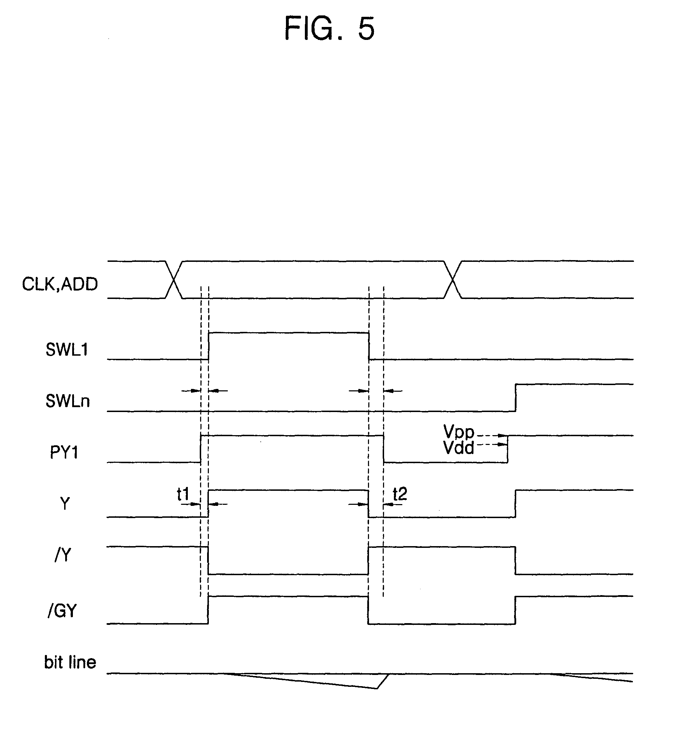

As illustrated by FIG. 5, operation of the global column unit **500** of FIG. 4 may be synchronized with a clock signal CLK (for a synchronous SRAM device) or an address ADD (for an asynchronous SRAM device). In advance of a leading edge of the clock signal CLK (or address ADD), the pair of partial bit lines PBL and /PBL and the pair of global bit lines GBL and /GBL may be precharged to logic 1 voltage levels by switching the partial column selection line PY1 low and also switching the global column selection signal /GY low. Thereafter, in response to the leading edge of the clock signal CLK (or address ADD), the partial column selection line PY1 is switched high to the boosted voltage level (e.g., PY1=Vpp) to thereby electrically connect the pair of partial bit lines PBL and /PBL to the pair of global bit lines GBL and /GBL and terminate the precharging operation. After a time interval of t1, the word line (e.g., SWL1) for an addressed row of SRAM cells is driven high (e.g., 1.5 Volts) so that data within the selected SRAM cell **4121** is passed to the corresponding pair of partial bit lines PBL and /PBL. The global column selection signal line /GY and the true column selection signal Y are also switched low-to-high (e.g., /GY=Y=Vdd) to terminate precharging of the pair of global bit lines GBL and /GBL and enable data on the pair of partial bit lines PBL and /PBL to be passed to the pair of global bit lines GBL and /GBL and to the pair of data lines DL and /DL. This read data is then sensed and amplified as a rail-to-rail signal by the sense amplifier 402.

After a sufficient amount of time, the selected word line SWL1, the true column selection signal Y and the global column selection signal line /GY are switched high-to-low. This causes the global bit lines GBL and /GBL to be precharged and disconnected from the pair of data lines DL and /DL. Then, after a time interval of t2, the partial column selection signal line PY1 is switched high-to-low to again precharge the partial bit lines PBL and /PBL. The above-described read operations may then be repeated for another row of memory cells **4121.**

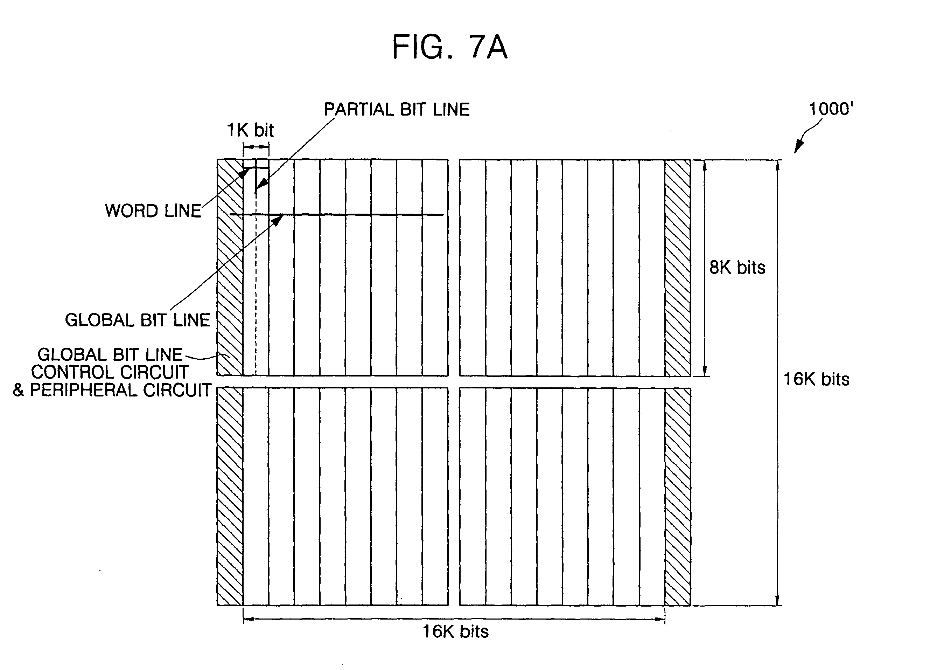

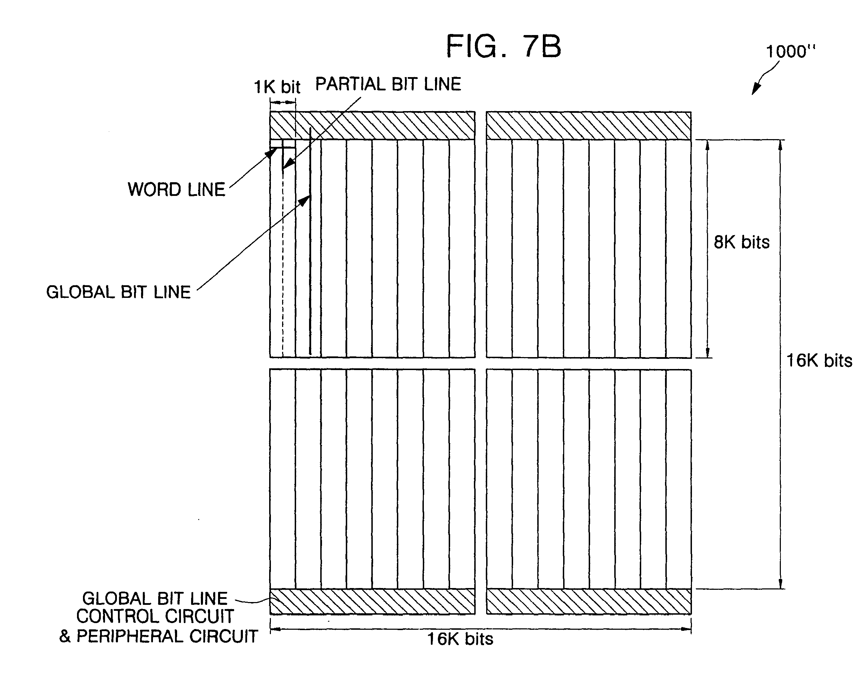

One 16k by 16k embodiment of the memory device **1000** of FIG. 4 is illustrated by FIG. 7A. This memory device **1000'** of FIG. 7A is arranged into four 8k by 8k quadrants. Each of these quadrants includes eight 1 k bit global column units. As illustrated, the word lines (SWLn) and the global bit lines (GBL and /GBL) extend parallel to each other, but in an orthogonal direction relative to the partial bit lines (PBL and /PBL). The shaded regions illustrate a global bit line and control circuit and peripheral circuit. The global bit line and control circuit includes the global bit line precharging and equalizing circuits **420** and the global bit line selection circuits **430** illustrated by FIG. 4. Another 16k by 16k embodiment of the memory device **1000** of FIG. 4 is illustrated by FIG. 7B. This memory device **1000"** of FIG. 7B is arranged into four 8k by 8k quadrants. Each of these quadrants includes eight 1 k bit global column units. As illustrated, the word lines (SWLn) and the global bit lines (GBL and /GBL) are orthogonal to each other, and the global bit lines and the partial bit lines (PBL and /PBL) are parallel to each other. The shaded regions illustrate a global bit line and control circuit and peripheral circuit. The global bit line and control circuit includes the global bit line precharging and equalizing circuits **420** and the global bit line selection circuits **430** illustrated by FIG. 4.

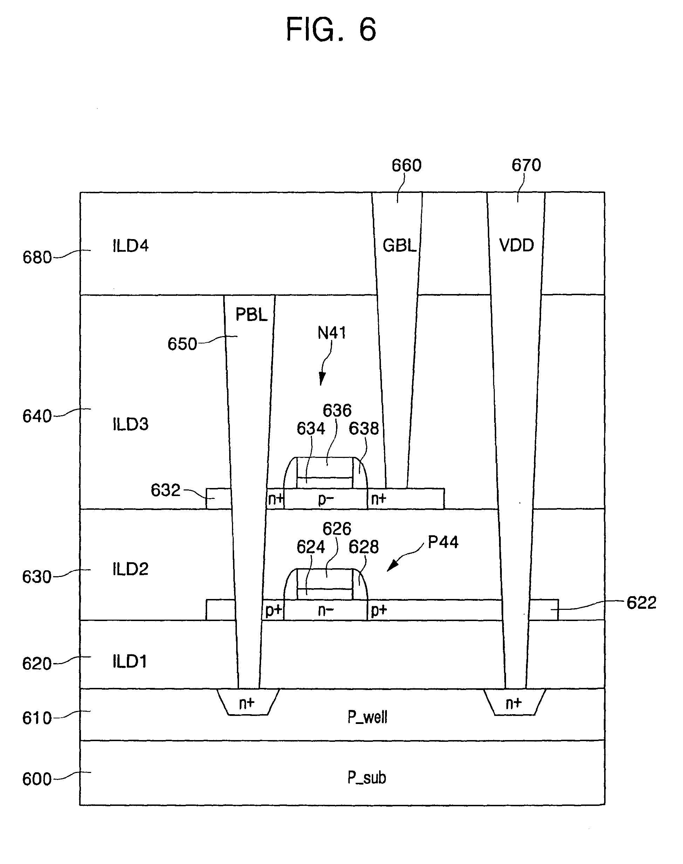

As illustrated by FIG. 6, the PMOS pull-up transistor P44 and the NMOS pass transistor N41 of FIG. 4 may be configured as thin-film transistors (TFTs), which are stacked vertically on a semiconductor substrate **600** (e.g., P-type substrate). Although not shown, the PMOS pull-up transistor P45 and the NMOS pass transistor N42 may also be configured as stacked thin-film transistors (TFTs) that are disposed side-by-side relative to the stacked transistors illustrated by FIG. 6. Accordingly, all the transistors within the partial bit line precharging circuit **414** and the partial bit line selection circuit **416** of FIG. 4 may be formed as a closely stacked arrangement of two pairs of single-crystal TFTs. The formation of these TFT transistors above the substrate **600** may eliminate a need to form alternating P-type and N-type conductivity regions within a portion of the substrate and thereby inhibit any occurrence of parasitic latch-up, which may result in regenerative current conduction within the substrate **600.**

In FIG. 6, a P-type well region **610** is shown as being disposed within the semiconductor substrate **600.** A plurality of interlayer dielectric layers are also provided on the substrate **600.** These dielectric layers include a first interlayer dielectric layer **620** (ILD1), a second interlayer dielectric layer **630** (ILD2), a third interlayer dielectric layer **640** (ILD3) and a fourth interlayer dielectric layer **680** (ILD4). The PMOS pull-up transistor P44 is defined by a single crystal silicon active layer **622** having source, drain and channel regions therein. This single crystal silicon active layer **622** is shown as being directly on the first interlayer insulating layer **620.** A gate electrode of the PMOS pull-up transistor P44 includes a gate insulating pattern **624,** a gate pattern **626** and sidewall spacers **628.** The NMOS pass transistor N41 is defined by a single crystal silicon active layer **632** having source, drain and channel regions therein. This single crystal silicon active layer **632** is shown as being directly on the second interlayer insulating layer **630** and stacked above the PMOS pull-up transistor P44. A gate electrode of the NMOS pass transistor N41 includes a gate insulating pattern **634,** a gate pattern **636** and sidewall spacers **638.**

A contact to the drain of the PMOS pull-up transistor P44 and a first current carrying terminal of the NMOS pass transistor N41 is provided by a partial bit line conductive via **650,** which is electrically connected to a partial bit line PBL (not shown in FIG. 6). A contact to the source of the PMOS pull-up transistor P44 is provided by a power supply line conductive via **670,** which is electrically connected to a power supply line Vdd (not shown in FIG. 6). A contact to a second current carrying terminal of the NMOS pass transistor N41 is provided by a global bit line conductive via **660,** which is electrically connected to a global bit line GBL (not shown in FIG. 6).

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. An integrated circuit memory device, comprising:
a first column (412) of memory cells (4121) electrically coupled to a first pair of bit lines (PBL, /PBL); and
a bit line precharge and selection circuit (414, 416),
**characterized in that**
the bit line precharge and selection circuit (414, 416) comprises a stacked arrangement of a first PMOS transistor and a first NMOS transistor (N41) electrically coupled to one of the first pair of bit lines.

2. The memory device of Claim 1, wherein the first PMOS transistor is a PMOS pull-up transistor and/or a PMOS thin-film transistor and/or the first NMOS transistor is a NMOS pass transistor and/or a NMOS thin-film transistor.

3. The memory device of Claim 1 or 2, wherein a first current carrying terminal of the PMOS transistor is electrically connected to a first current carrying terminal of the NMOS transistor and a true one of the first pair of bit lines.

4. The memory device of any of Claims 1 to 3, wherein a gate terminal of the PMOS transistor is electrically connected to a gate terminal of the NMOS transistor.

5. The memory device of Claim 3 or 4, wherein a second current carrying terminal of the PMOS transistor is electrically connected to a power supply line and a second current carrying terminal of the NMOS transistor is electrically connected to a global bit line.

6. The integrated circuit memory device of any of claims 1 to 5, wherein
a second column of memory cells electrically coupled to a second pair of bit lines is provided;
the first bit line precharge and selection circuit further comprises a stacked arrangement of a second PMOS transistor (P45) and a second NMOS transistor (N42) electrically coupled to a complementary one of the first pair of bit lines; and
a pair of global bit lines (GBL, /GBL) is electrically coupled to the first and second NMOS transistors.

7. The memory device of Claim 6, further comprising:
a pair of data lines (DL, /DL);
a precharge and equalization circuit (420) electrically coupled to said pair of global bit lines; and
a global bit line selection circuit (430) electrically coupled to said precharge and equalization circuit and said pair of data lines.

8. The memory device of Claim 6 or 7, wherein a second bit line precharge and selection circuit is provided which comprises
a stacked arrangement of a third PMOS thin-film transistor and a third NMOS thin-film transistor electrically coupled to a true one of the second pair of bits lines; and
a stacked arrangement of a fourth PMOS thin-film transistor and a fourth NMOS thin-film transistor electrically coupled to a complementary one of the second pair of bit lines.

9. The memory device of Claim 8, wherein said pair of global bit lines is electrically coupled to the third and fourth NMOS thin-film transistors.

10. The integrated circuit memory device of any of claims 1 to 9, wherein the memory cells are thin-film transistor (TFT) SRAM cells.

11. The integrated circuit memory device of Claim 10, wherein each of the TFT SRAM cells is a 6T cell comprising four TFT transistors stacked over two planar transistors, which are disposed within a semiconductor substrate.

12. The integrated circuit memory device of Claim 11, wherein the four TFT transistors include two TFT PMOS pull-up transistors and two TFT NMOS access transistors, and wherein the two planar transistors include two NMOS pull-down transistors.
